# EUROPÄISCHE PATENTSCHRIFT

(11) **EP 1 797 601 B1**
(45) Veröffentlichungstag und Bekanntmachung des Hinweises auf die Patenterteilung: **02.07.2008**
(21) Anmeldenummer: 05796950.3
(22) Anmeldetag: 27.09.2005
(51) Int. Cl.: H01L 39/16

(54) **VORRICHTUNG ZUR RESISTIVEN STROMBEGRENZUNG MIT BANDFÖRMIGER HOCH-Tc-SUPRALEITERBAHN**
DEVICE FOR RESISTIVELY LIMITING CURRENT, COMPRISING A STRIP-SHAPED HIGH-Tc-SUPER CONDUCTOR PATH
DISPOSITIF DE LIMITATION RESISTIVE DE COURANT POURVU D'UNE PISTE SUPRACONDUCTRICE A HAUTE Tc EN FORME DE BANDE

(30) Priorität: 04.10.2004 DE 102004048644
(43) Veröffentlichungstag der Anmeldung: 20.06.2007
(73) Patentinhaber: SIEMENS AKTIENGESELLSCHAFT, 80333 München (DE)
(72) Erfinder: KRÄMER, Hans-Peter, 91058 Erlangen (DE); SCHMIDT, Wolfgang, 91056 Erlangen (DE)
(86) Internationale Anmeldenummer: PCT/EP2005/054855
(87) Internationale Veröffentlichungsnummer: WO 2006/037742

(56) Entgegenhaltungen:
- WO-A-99/33122
- DE-A1- 10 226 391
- DE-C1- 4 434 819

## Beschreibung

Die Erfindung bezieht sich auf eine resistive supraleitende Strombegrenzervorrichtung mit einer Leiterbahn aus einem bandförmigen Supraleiter, dessen Leiteraufbau zumindest ein Substratband aus einem normalleitenden Substratmetall, eine supraleitende Schicht aus einem oxidischen Hoch-T_{c}-Supraleitermaterial vom AB₂Cu₃Oₓ-Typ mit A zumindest einem Seltenen Erdmetall einschließlich Yttrium und B mindestens einem Erdalkalimetall, eine dazwischen angeordnete Pufferschicht aus einem isolierenden, oxidischen Puffermaterial sowie eine auf der supraleitenden Schicht aufgebrachte Deckschicht aus einem normalleitenden Deckschichtmaterial enthält. Eine entsprechende Strombegrenzervorrichtung geht aus der DE 199 09 266 A1 hervor. Eine derartige strombegrenzungsvorrichtung geht auch aus der WO 99/33122 hervor.

Seit 1986 sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und insbesondere eine Flüssig-Stickstoff (LN₂)-Kühltechnik erlauben. Unter solche Metalloxidverbindungen fallen insbesondere Cuprate auf Basis spezieller Stoffsysteme wie z.B. vom Typ AB₂Cu₃Oₓ, wobei A zumindest ein Seltenes Erdmetall einschließlich Yttrium und B mindestens ein Erdalkalimetall sind. Hauptvertreter dieses Stoffsystems vom sogenannten 1-2-3-HTS-Typ ist das sogenannte YBCO (Y₁Ba₂Cu₃Oₓ mit 6,5 ≤ x ≤ 7).

Dieses bekannte HTS-Material versucht man, auf verschiedenen Substraten für unterschiedliche Anwendungszwecke abzuscheiden, wobei im Allgemeinen nach möglichst phasenreinem Supraleitermaterial getrachtet wird. So werden insbesondere metallische Substrate für Leiteranwendungen vorgesehen (vgl. z.B. EP 0 292 959 A1).

Bei einem entsprechenden Leiteraufbau wird das HTS-Material im Allgemeinen nicht unmittelbar auf einem als Substrat dienenden Trägerband abgeschieden; sondern dieses Substratband wird zunächst mit wenigstens einer dünnen Zwischenschicht, die auch als Pufferschicht (bzw. "Buffer"-Schicht) bezeichnet wird, abgedeckt. Diese Pufferschicht mit einer Dicke in der Größenordnung von 1 µm soll einerseits das Eindiffundieren von Metallatomen aus dem Substrat in das HTS-Material verhindern, welche die supraleitenden Eigenschaften verschlechtern könnten. Zum anderen soll die Pufferschicht eine texturierte Ausbildung des HTS-Materials ermöglichen. Entsprechende Pufferschichten bestehen im Allgemeinen aus Oxiden von Metallen wie Zirkon, Cer, Yttrium, Aluminium, Strontium oder Magnesium oder Mischkristallen mit mehreren dieser Metalle und sind somit elektrisch isolierend. In einer entsprechenden stromleitenden Leiterbahn ergibt sich dadurch eine Problematik, sobald das supraleitende Material in den normalleitenden Zustand übergeht (sogenanntes "Quenchen"). Dabei wird der Supraleiter zunächst streckenweise resistiv und nimmt so einen Widerstand R an, z.B. indem er sich über die Sprungtemperatur T_{c} seines Supraleitermaterial erwärmt (in sogenannten "Hot Spots" oder Teilquenchbereichen) und sich meist weiter erhitzt, so dass die Schicht durchbrennen kann.

Auf Grund dieser Problematik ist es bekannt, direkt auf der HTS-Leitungsschicht eine zusätzliche metallische Deckschicht aus einem elektrisch gut leitenden, mit dem HTS-Material verträglichen Material wie Au oder Ag als Shunt gegen ein Durchbrennen aufzubringen. Das HTS-Material steht also in einem elektrisch leitenden, flächenhaften Kontakt mit der metallischen Deckschicht (vgl. DE 44 34 819 C).

Wegen der auch mit Shunts vorhandenen Hot-Spots oder Teilquenchbereiche verteilt sich die Spannung ungleichmäßig längs der Supraleiterschicht. In dem die supraleitende Schicht tragenden Substratband fällt hingegen die an den Enden angelegte Spannung U gleichmäßig über die gesamte Länge ab bzw. es befindet sich auf einem undefinierten Zwischenpotential, falls die Enden von der angelegten Spannung isoliert sind. Die Folge davon können unter Umständen Spannungsdifferenzen von der Leiterbahn über die Pufferschicht zum Substrat sein. Dies führt wegen der geringen Dicke dieser Schicht unvermeidlich zu elektrischen Durchschlägen und so zu punktueller Zerstörung der Pufferschicht und gegebenenfalls der Supraleitungsschicht. Für einen Durchschlag reichen typischerweise Spannungen in der Größenordnung von 20 bis 100 Volt für Pufferschichtdicken von 1 µm aus. Eine entsprechende Problematik ergibt sich insbesondere dann, wenn mit entsprechenden Leiterbändern resistive Strombegrenzereinrichtungen erstellt werden sollen. Bei einer solchen Einrichtung wird nämlich der Übergang vom supraleitenden in den normalleitenden Zustand zur Strombegrenzung im Kurzschlussfall ausgenutzt. Es ist hier nicht ohne weiteres möglich, die Pufferschicht ausreichend spannungsfest für die für solche Einrichtungen üblichen Betriebsspannungen im kV-Bereich zu machen.

Bei der aus der eingangs genannten DE-A1-Schrift zu entnehmenden Strombegrenzervorrichtung wird ein bandförmiger Supraleiter mit einem entsprechenden Aufbau verwendet. Bei diesem Aufbau besteht die angesprochene Gefahr von elektrischen Durchschlägen über die Pufferschicht.

Aufgabe der vorliegenden Erfindung ist es, bei einer resistiven supraleitenden Strombegrenzervorrichtung mit den eingangs genannten Merkmalen diese Gefahr eines elektrischen Durchschlags bei einem Quenchen im Strombegrenzungsfall auszuschließen.

Diese Aufgabe wird mit den in Anspruch 1 angegebenen Maßnahmen gelöst. Demgemäß soll bei der Strombegrenzervorrichtung mit den eingangs genannten Merkmalen zumindest in Teilbereichen wenigstens eine der Seitenkanten des Leiteraufbaus so mechanisch deformiert sein, dass sich die Deckschicht und das Substratband in elektrischem Kontakt befinden.

Die mit dieser Ausbildung der Strombegrenzervorrichtung verbundenen Vorteile sind insbesondere darin zu sehen, dass das metallische Substratband und die normalleitende Deckschicht und damit auch die mit ihr galvanisch verbundene supraleitende Schicht in Stromführungsrichtung gesehen zumindest in den Teilbereichen entlang der Länge des Aufbaus im gegenseitigen elektrischen Kontakt gebracht sind und somit auf einem einzigen elektrischen Potential auch im Falle eines Quenches liegen. Auf diese Weise wird ein Durchschlag über die Pufferschicht unterbunden. Eine entsprechende Deformation an wenigstens einer der Längsseiten des Leiteraufbaus ist insofern vertretbar, als im Normalfall die supraleitenden Eigenschaften der supraleitenden Schicht an den seitlichen Rändern sowieso herstellungsbedingt verschlechtert sind.

Bei der vorgeschlagenen Strombegrenzervorrichtung können insbesondere noch folgende Maßnahmen im Einzelnen oder auch in Kombination zusätzlich vorgesehen werden:

So kann der elektrische Kontakt an der wenigstens einen Seitenkante durch eine Quetsch- oder Walzverformung gebildet sein. Entsprechende Verformungen sind leicht auszuführen.

Weitere vorteilhafte Ausgestaltungen der Strombegrenzereinrichtung nach der Erfindung gehen aus den vorstehend nicht angesprochenen Unteransprüchen hervor.

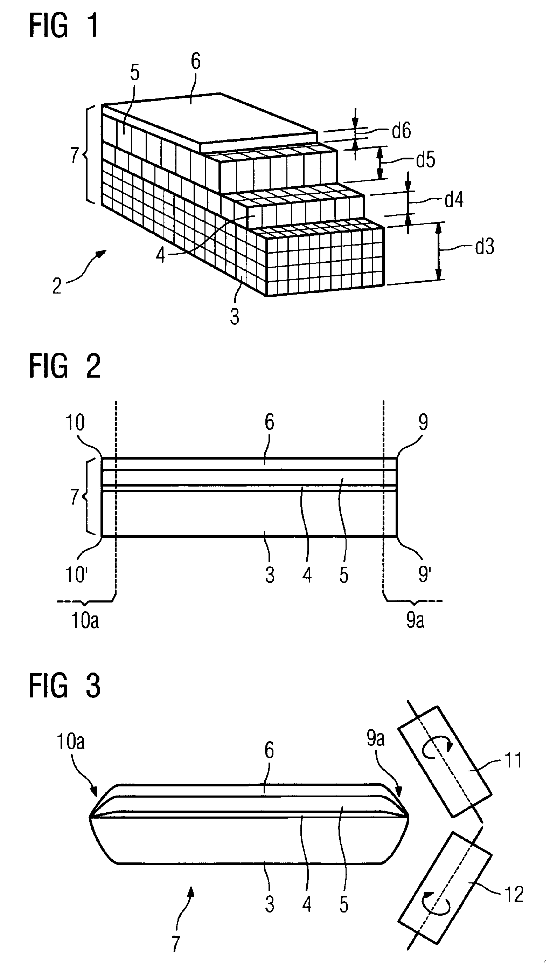

Zur weiteren Erläuterung der Erfindung wird nachfolgend auf die Zeichnung Bezug genommen, an Hand derer bevorzugte Ausführungsbeispiele von Strombegrenzereinrichtungen erläutert sind. Dabei zeigen jeweils in stark schematisierter Form
- deren Figur 1: den Aufbau eines YBCO-Bandleiters der Strombegrenzereinrichtung in Schrägaufsicht,
- deren Figur 2: diesen Bandleiter in Querschnittsansicht vor einer Kantenverformung
sowie
- deren Figur 3: diesen Bandleiter in Querschnittsansicht nach einer solchen Verformung.

Dabei sind in den Figuren sich entsprechende Teile jeweils mit denselben Bezugszeichen versehen.

Bei dem in Figur 1 angedeuteten, allgemein mit 2 bezeichneten Bandleiter wird von an sich bekannten Ausführungsformen von sogenannten YBCO-Bandleitern oder "YBCO Coated Conductors" ausgegangen. In der Figur sind bezeichnet mit
3 ein Substratband aus einem normalleitenden Substratmetall der Dicke d3,
4 wenigstens eine darauf aufgebrachte Pufferschicht aus einem isolierenden, oxidischen Puffermaterial der Dicke d4,
5 eine HTS-Schicht aus YBCO der Dicke d5,
6 eine Deckschicht aus einem normalleitenden Deckmetall der Dicke d6 als eine Schutz- und/oder Kontaktschicht
   sowie
7 der Leiteraufbau aus diesen vier Teilen.

Dabei kann man diese Teile wie folgt ausbilden:
- Ein metallisches Substratband 3 aus Ni, Ni-Legierungen oder Edelstahl mit einer Dicke d3 von etwa 50 bis 250 µm,
- wenigstens eine Pufferschicht oder ein Pufferschichtensystem aus einer oder mehreren Lagen von Oxiden wie CeO₂ oder YSZ mit einer Dicke d4 von etwa 0,1 bis 1,5 µm; d.h.; die Pufferschicht kann dabei in an sich bekannter Weise auch als ein System aus mehreren Lagen aus verschiedenem oxidischen Material zusammengesetzt sein,
- wenigstens eine HTS-Schicht 5 aus YBCO mit einer Dicke d5 zwischen etwa 0,3 und 3 µm,
   und
- wenigstens eine metallische Deckschicht 6 aus Ag, Au oder Cu mit einer Dicke d6 zwischen etwa 0,1 µm und 1 mm. Die Deckschicht kann dabei auch aus mehreren Lagen aus metallischem Material, gegebenenfalls verschiedenen Metallen zusammengesetzt sein.

Ein entsprechender Bandleiter ist einige Millimeter bis wenige Zentimeter breit. Seine supraleitende Stromfähigkeit wird von der YBCO-Schicht 5, d.h. von deren kritischer Stromdichte bestimmt, während die thermischen, mechanischen und normalleitenden Eigenschaften wegen der größeren Dicke d3=dₛ von dem Substratband 3 dominiert werden. Dabei bildet das Substratband zusammen mit der Pufferschicht eine Unterlage für ein quasi einkristallines Wachstum des YBCO. Substratbandmaterial und Pufferschichtmaterial dürfen im thermischen Ausdehnungskoeffizienten und in ihren kristallographischen Gitterkonstanten nicht zu weit vom YBCO abweichen. Je besser die Anpassung desto höher ist die rissfreie Schichtdicke und desto besser die Kristallinität des YBCO. Darüber hinaus ist für hohe kritische Stromdichten im MA/cm²-Bereich eine möglichst parallele Ausrichtung der Kristallachsen in benachbarten Kristalliten gewünscht. Dies erfordert eine eben solche Ausrichtung zumindest in der obersten Pufferschicht, damit das YBCO heteroepitaktisch aufwachsen kann. Die Präparation solcher quasi einkristalliner flexibler Substrat-Puffersysteme gelingt bevorzugt mit drei Verfahren:
- Sogenanntes "Ion Beam Assisted Deposition (IBAD)" von meist YSZ oder MgO auf untexturierten Metallbändern,
- sogenannte "Inclined Substrate Deposition (ISD)" von YSZ oder MgO auf untexturierten Metallbändern,
- sogenannte "Rolling Assisted Biaxially Textured Substrates (RABiTS)", d.h. durch Walz- und Glühbehandlung in Würfellage gebrachte Substrate mit heteroepitaktischem Puffersystem.

Die auf dem Substratband abzuscheidenden Funktionsschichten 4 bis 6 werden in an sich bekannter Weise mit Vakummbeschichtungsverfahren (PVD), chemischer Abscheidung aus der Gasphase (CVD) oder aus chemischen Lösungen (CSD) hergestellt.

Selbstverständlich können zwischen den einzelnen Schichten des Aufbaus 7 noch vergleichsweise dünnere, sich bei der Herstellung des Aufbaus bzw. der Abscheidung der einzelnen Schichten insbesondere durch Diffusions- und/oder Reaktionsvorgänge ausbildende Zwischenschichten vorhanden sein.

Im Vergleich zu den für YBCO-Dünnschicht-Strombegrenzer bekannten keramischen Plattenleitern ist bei Bandleitern des vorstehend geschilderten Typs das Substratband 3 elektrisch leitfähig, d.h. es kann den begrenzten Strom tragen und als Shunt wirken. Mit dem in der Figur gezeigten Leiteraufbau 7 wären jedoch die HTS-Schicht 5 und das Substratband 3 voneinander isoliert. Sobald die Strombegrenzungseinrichtung in ihren begrenzenden Zustand übergeht, d.h. normalleitend wird und sich eine Spannung längs der Leiterbahn aufbaut, wird die Durchschlagsfeldstärke der bekannten Pufferschichtmaterialien, die in der Größenordnung von 100 kV/mm = 10 V/0,1 µm liegen, schnell überschritten. D.h., die Pufferschicht 4 würde dann unkontrolliert durchschlagen. Daher ist erfindungsgemäß ein guter elektrischer Kontakt zwischen der Supraleitungsschicht 5 und dem metallischen Substratband 3 bevorzugt auf der ganzen Leiterlänge für den Einsatz von Bandleitern in Strombegrenzern vorteilhaft.

Eine entsprechende durchgängige Kontaktierung über die ganze Länge lässt sich aus der Ausführungsform nach den Figuren 2 und 3 ersehen. Dabei zeigt Figur 2 den Leiteraufbau 7 vor einer Verformungsbehandlung in Seitenbereichen 9a und 9b. Eine Verformung in diesen Bereichen ist im Allgemeinen unproblematisch, weil dort die supraleitenden Eigenschaften der Supraleitungsschicht 5 gegenüber einem mittleren Bereich des Leiters häufig verschlechtert sind.

Gemäß Figur 3 kann man beispielsweise mit Hilfe von Kantenrollen 11 und 12 die gewünschte Verformung vornehmen. Die Rollen wirken dabei auf die jeweiligen Seitenkanten 9, 9' und/oder 10, 10' derart ein, dass der Aufbau von dort aus in etwa diagonaler Richtung zusammengedrückt wird. Dabei wird das Deckschichtmaterial an das mechanisch robustere Substratband herangedrückt, so dass zumindest in Teilbereichen der Längsseite des Leiterbandes eine galvanische Verbindung zwischen dem metallischen Material der Deckschicht 6 und dem metallischen Material des Substratbandes 3 geschaffen wird.

Bei den vorstehenden Ausführungsbeispielen wurde YBCO als HTS-Material für die supraleitende Schicht 5 zugrunde gelegt. Selbstverständlich sind auch andere HTS-Materialien vom sogenannten 1-2-3-Typ mit anderen Seltenen Erdmetallen und/oder anderen Erdalkalimetallen einsetzbar. Die einzelnen Komponenten dieser Materialien können auch in an sich bekannter Weise teilweise durch weitere/andere Komponenten substituiert sein.

## Patentansprüche

1. Resistive supraleitende Strombegrenzervorrichtung mit einer Leiterbahn (2) aus einem bandförmigen Supraleiter, dessen Leiteraufbau (7) zumindest
- ein Substratband (3) aus einem normalleitenden Substratmetall,
- supraleitende Schicht (5) aus einem oxidischen Hoch-T_{c}-Supraleitermaterial vom AB₂CU₃Oₓ-Typ mit A für mindestens ein seltenes Erdmetall einschließlich Yttrium und B für mindestens ein Erdalkalimetall,
- eine dazwischen angeordnete Pufferschicht (4) aus einem isolierenden, oxidischen Puffermaterial
sowie
- eine auf der supraleitenden Schicht (5) aufgebrachte Deckschicht (6) aus einem normalleitenden Deckschichtmaterial
enthält, **dadurch gekennzeichnet, dass** zumindest in Teilbereichen wenigstens eine der Seitenkanten (9, 9' oder 10, 10') des Leiteraufbaus (7) so mechanisch deformiert ist, dass sich die Deckschicht (6) und das Substratband (3) in elektrischem Kontakt befinden.

2. Strombegrenzervorrichtung nach Anspruch 1, **dadurch gekennzeichnet, dass** der elektrische Kontakt an der wenigstens einen Seitenkante (9, 9' oder 10, 10') durch eine Quetsch- oder Walzverformung gebildet ist.

3. Strombegrenzervorrichtung nach Anspruch 1 oder 2, **dadurch gekennzeichnet, dass** die Deckschicht (6) aus mehreren Lagen aus metallischem Material zusammengesetzt ist.

4. Strombegrenzervorrichtung nach einem der vorangehenden Ansprüche, **dadurch gekennzeichnet, dass** die Pufferschicht (4) aus mehreren Lagen aus oxidischem Material zusammengesetzt ist.

## Claims

1. Resistive superconducting current limiter device comprising a conductor track (2) composed of a strip-type superconductor, the conductor construction (7) of which contains at least
- a substrate strip (3) composed of a normally conducting substrate metal,
- superconducting layer (5) composed of an oxidic high-T_{c} superconductor material of the AB₂CU₃Oₓ type where A denotes at least one rare earth metal including yttrium and B denotes at least one alkaline earth metal,
- a buffer layer (4) arranged in between, said buffer layer being composed of an insulating, oxidic buffer material, and also
- a cover layer (6) applied on the superconducting layer (5), said cover layer being composed of a normally conducting cover layer material, **characterized in that**, at least in partial regions, at least one of the lateral edges (9, 9' or 10, 10') of the conductor construction (7) is mechanically deformed in such a way that the cover layer (6) and the substrate strip (3) are in electrical contact.

2. Current limiter device according to Claim 1, **characterized in that** the electrical contact at the at least one lateral edge (9, 9' or 10, 10') is formed by a crimping or rolling deformation.

3. Current limiter device according to Claim 1 or 2, **characterized in that** the cover layer (6) is composed of a plurality of layers of metallic material.

4. Current limiter device according to one of the preceding Claims, **characterized in that** the buffer layer (4) is composed of a plurality of layers of oxidic material.

## Revendications

1. Dispositif résistif supraconducteur de limitation du courant comprenant une piste (2) conductrice en un supraconducteur en forme de ruban dont la structure (7) de conducteur comporte au moins
- un ruban (3) de substrat en un métal de substrat normalement conducteur ;
- une couche (5) supraconductrice en un matériau supraconducteur oxydé à T_{c} haute du type AB₂CU₃Oₓ, A représentant au moins un métal de terres rares, y compris l'yttrium, et B au moins un métal alcalino-terreux ;
- une couche (4) tampon interposée entre eux en un matériau tampon isolant oxydé ;
ainsi que
- une couche (6) de finition, déposée sur la couche (5) supraconductrice et en un matériau de couche de finition normalement conducteur, **caractérisé en ce qu'**au moins dans des zones partielles au moins l'une des arêtes (9, 9' ou 10, 10') latérales de la structure (7) de conducteur est déformée mécaniquement de façon à ce que la couche (6) de finition et la bande (3) de substrat se trouvent en contact électrique.

2. Dispositif de limitation du courant suivant la revendication 1, **caractérisé en ce que** le contact électrique sur la au moins une arête (9, 9' ou 10, 10') latérale est formé par une déformation par pincement ou par laminage.

3. Dispositif de limitation du courant suivant la revendication 1 ou 2, **caractérisé en ce que** la couche (6) de finition est composée de plusieurs strates de matériau métallique.

4. Dispositif de limitation du courant suivant l'une des revendications précédentes, **caractérisé en ce que** la couche (4) tampon est composée de plusieurs strates de matériau oxydé.
